# EUROPÄISCHE PATENTSCHRIFT

(11) **EP 2 430 467 B1**
(45) Veröffentlichungstag und Bekanntmachung des Hinweises auf die Patenterteilung: **15.11.2017**
(21) Anmeldenummer: 10718609.0
(22) Anmeldetag: 11.05.2010
(51) Int. Cl.: G01R 31/36, E05B 1/00, E05B 17/10, E05B 85/10

(54) **VORRICHTUNG UND VERFAHREN ZUR ABFRAGE DES LADEZUSTANDES EINER BATTERIE EINES FAHRZEUGS MIT ELEKTROANTRIEB**
DEVICE AND METHOD FOR INQUIRING THE CHARGE STATE OF A BATTERY OF A VEHICLE HAVING AN ELECTRIC DRIVE
DISPOSITIF ET PROCÉDÉ POUR INTERROGER L'ÉTAT DE CHARGE D'UNE BATTERIE D'UN VÉHICULE À MOTEUR À ENTRAÎNEMENT ÉLECTRIQUE

(30) Priorität: 12.05.2009 DE 102009003043
(43) Veröffentlichungstag der Anmeldung: 21.03.2012
(73) Patentinhaber: Huf Hülsbeck & Fürst GmbH & Co. KG, 42551 Velbert (DE)
(72) Erfinder: MÖNIG, Stefan, 58332 Schwelm (DE); MOREAU, Jean-Yves, F-93800 Epinay sur Seine (FR)
(74) Vertreter: Zenz Patentanwälte Partnerschaft mbB
(86) Internationale Anmeldenummer: PCT/EP2010/056470
(87) Internationale Veröffentlichungsnummer: WO 2010/130743

(56) Entgegenhaltungen:
- DE-A1-102006 038 049
- DE-A1-102008 007 801
- US-A- 5 939 861
- US-A1- 2006 232 379
- US-A1- 2008 018 437

## Beschreibung

Die Erfindung betrifft eine Außengriffanordnung und einen Identifikationsgeber eines Fahrzeugs mit Elektroantrieb. Ebenso betrifft die Erfindung ein Verfahren zur Abfrage von Informationssignalen über den Ladezustand einer zur Speisung eines Fahrzeugs mit Elektroantrieb dienenden Batterieeinheit.

Eine Batterieeinheit wird bei zahlreichen Anwendungen verwendet, bei denen die Kenntnis der in der Batterieeinheit noch zur Verfügung stehenden Energie von großer Bedeutung ist. Beispielsweise werden im Kraftfahrzeugbereich aufladbare Batterieeinheiten verwendet, die dem Antrieb eines Fahrzeugs mit Elektroantrieb dienen. Eine Information bezüglich der in der Batterieeinheit gespeicherten Energie wird üblicherweise ortsfest im Fahrzeuginneren auf einer der Instrumententafel zugeordneten Anzeigeeinheit dargestellt. Der Benutzer des Fahrzeugs mit Elektroantrieb muss sich auf diese angezeigte Information verlassen können, weil eine Wiederaufladung spezielles Gerät erfordert, das nicht standardmäßig an Tankstellen sondern nur an einer speziellen Ladestation zur Verfügung steht. Mittels Kontrolle der diesbezüglichen Anzeige im Fahrzeuginneren muss der Benutzer des Fahrzeugs sicherstellen, dass die Batterieeinheit für die anstehende und/oder die gegenwärtige Fahrt hinreichend Energie zur Verfügung stellt, um an dem gewünschten Zielort anzukommen, und dass das Fahrzeug zu einer Ladestation zurückgebracht werden kann, bevor die Batterieeinheit vollständig entladen ist. Um den aktuellen Ladezustand der Batterieeinheit zu ermitteln, muss der Benutzer des Fahrzeugs auf die im Fahrzeuginneren angeordnete Anzeigeeinheit zurückgreifen, selbst wenn sich das Fahrzeug zur Aufladung der Batterieeinheit an einer Ladestation befindet.

Aus der DE 10 2008 007 801 A1 ist ein Verfahren und eine Vorrichtung zur Überwachung einer Fahrzeugbatterie bekannt. Bei dem Verfahren wird eine Information über den Batteriezustand derart zur Verfügung gestellt, dass die Information von außerhalb des Kraftfahrzeugs wahrnehmbar ist. Zu diesem Zweck sind außen am Kraftfahrzeug angebrachte Leuchtdioden vorgesehen, die im normalen Betrieb des Kraftfahrzeugs zur Fahrtrichtungsanzeige oder als Bremslichter verwendet werden und die nur dann als optische Anzeigevorrichtung zur Darstellung des Batteriezustandes benutzt werden, wenn sich das Kraftfahrzeug beispielsweise für einen Überseetransport in einem Energiesparmodus befindet.

Ferner ist aus der US 2006/0232379 A1 ein Türaußengriff für ein Passive-Entry-System eines Kraftfahrzeugs bekannt, das farblich unterschiedliche LED's umfasst. Die LED's können zum Beispiel zur Beleuchtung des Türgriffs, zur Vorfeldbeleuchtung oder zur Anzeige des Öffnungs-/Schließzustandes der Tür verwendet werden.

Darüber hinaus offenbart die US 2008/0018347 A1 einen beleuchteten Fahrzeuggriff, der als Einstiegshilfe zum Beispiel bei Arbeitsfahrzeugen verwendet wird. Der Fahrzeuggriff weist eine Tastatur mit einer Vielzahl von Knöpfen auf, die einen schlüssellosen Zugang zum Fahrzeug oder andere Steuerungsmöglichkeiten für das Fahrzeug bieten. Zur Beleuchtung wird wenigstens eine lichtemittierende Diode verwendet, wobei weitere lichtemittierende Dioden in unterschiedlichen Farben anzeigen können, ob die Fahrzeugtür geschlossen oder geöffnet ist.

Aus der US 5,939,861 ist ein Kontrollsystem für eine Batterie eines Fahrzeugs bekannt. Eine erste lichtemittierende Anzeige ist mit einem Batteriesensor verbunden und zeigt farblich einen ersten vorbestimmten Batterieladezustand an. Mittels einer zweiten lichtemittierenden Anzeige kann ein zweiter vorbestimmter Batterieladezustand mit von der ersten Anzeige abweichender Farbe dargestellt werden. Beide Anzeigen sind direkt an dem Gehäuse des Batteriesensors angeordnet, der auf der Batterie angebracht ist.

Schließlich offenbart die DE 10 2006 038 049 A1 eine Vorrichtung zur Batteriezustandsüberwachung für ein Kraftfahrzeug, bei der ein Sensor die Batteriespannung und die Batterietemperatur ermittelt und diese Messgrößen in Form von elektrischen Signalen einer ersten elektronischen Schaltung zur weiteren Verarbeitung bereitstellt. Eine zweite elektronische Schaltung ist vorgesehen, die eine Powerline-Kommunikation bereitstellt, mit der die Sensorsignale über die bestehende Fahrzeugverkabelung zur Zigarettenanzünderdose drahtgebunden gesendet werden. Mittels einer dritten elektronischen Schaltung, die an der Steckdose des Zigarettenanzünders vorgesehen ist, können die Sensorsignale in Funksignale umgewandelt und beispielsweise an ein empfangsfähiges PDA-Gerät gesendet werden. Der Erfindung liegt daher die Aufgabe zugrunde, eine Lösung zu schaffen, die einem Benutzer eines Fahrzeugs mit Elektroantrieb einen verbesserten Komfort zur Ermittlung des Ladezustands einer zur Speisung eines Fahrzeugs dienenden Batterieeinheit bietet.

Diese Aufgabe wird erfindungsgemäß durch eine Tür-Außengriffanordnung gemäß Ansprüchen 1 und 2 sowie ein Verfahren gemäß Ansprüchen 13 und 14 gelöst.

Gemäß der Erfindung weist die Tür-Außengriffanordnung eines Fahrzeugs mit Elektroantrieb eine den Ladezustand einer Batterieeinheit darstellende optische Anzeigeeinheit auf, die von einer Vorrichtung zur Bestimmung des Ladezustandes der Batterieeinheit Informationssignale über den aktuellen Ladezustand der zur Speisung des Fahrzeugs dienenden Batterieeinheit erhält, wobei die optische Anzeigeeinheit in einem Außengriff des Fahrzeugs integriert ist und den aktuellen Ladezustand der Batterieeinheit in Reaktion auf ein die optische Anzeigeeinheit aktivierendes Ereignis darstellt. Aus Gründen der Energieeinsparung ist eine permanente Darstellung des Ladezustandes der Batterieeinheit in der im Außengriff integrierten optischen Anzeigeeinheit nicht erwünscht, so dass eine Darstellung der diesbezüglichen Information lediglich in Reaktion auf ein die optische Anzeigeeinheit aktivierendes Ereignis erfolgt. Daher ist vorgesehen, dass das die Darstellung des aktuellen Ladezustands der Batterieeinheit auslösende Ereignis eine Handhabung eines berechtigten Identifikationsgebers ist. Hierbei wird ein am Identifikationsgeber ausgebildetes Betätigungselement betätigt, um die optische Anzeigeeinheit zu aktivieren.

Gemäß dem erfindungsgemäßen Verfahren zur Abfrage von Informationssignalen über den Ladezustand einer zur Speisung eines Fahrzeugs mit Elektroantrieb dienenden Batterieeinheit wird von einem berechtigten Identifikationsgeber ein den aktuellen Ladezustand der Batterieeinheit betreffendes Abfragesignal an das Fahrzeug gesendet, der aktuelle Ladezustand der Batterieeinheit von dem Fahrzeug ermittelt, und der aktuelle Ladezustand der Batterieeinheit in Form eines Informationssignals an eine optische Anzeigeeinheit, die in einem Außengriff des Fahrzeugs integriert ist, übertragen, wobei der in dem übertragenen Informationssignal enthaltene aktuelle Ladezustand der Batterieeinheit von der optischen Anzeigeeinheit optisch erfassbar dargestellt wird. Durch Betätigung eines am berechtigten Identifikationsgeber ausgebildeten Betätigungselements wird das Abfragesignal über den aktuellen Ladezustand der Batterieeinheit an das Fahrzeug gesendet.

Vorteilhafte und zweckmäßige Ausgestaltungen und Weiterbildungen der Erfindung ergeben sich aus den entsprechenden Unteransprüchen.

Mit der Erfindung wird auf konstruktiv einfache Weise kostengünstig eine Möglichkeit geschaffen, die es einem Benutzer des Fahrzeugs mit Elektroantrieb ermöglicht, den aktuellen Ladezustand der dem Antrieb des Fahrzeugs dienenden Batterieeinheit zu ermitteln, ohne dass hierzu auf eine in dem Fahrzeuginneren angeordnete Anzeige zurückgegriffen werden muss. Der Benutzer kann somit vor Fahrtantritt - ohne in das Fahrzeug einsteigen zu müssen - ermitteln, ob der Ladezustand der Batterieeinheit für die gewünschte Fahrt ausreichend ist. Darüber hinaus ist es für den Benutzer mittels des Identifikationsgebers mit optischer Anzeigeeinheit möglich, den aktuellen Ladezustand abzufragen, ohne dass ein visueller Kontakt zum Fahrzeug dazu notwendig ist. Sowohl der Außengriff mit integrierter optischer Anzeige als auch der Identifikationsgeber mit optischer Anzeige ermöglichen es somit dem Benutzer vor Fahrtantritt und noch vor dem Einsteigen ins Fahrzeug zu erkennen, ob die Batterieeinheit für die bevorstehende Fahrt ausreichend Energie aufweist. Bei einem vorhandenen Außengriff mit einer elektrischen Schließvorrichtung können darüber hinaus die dafür vorhandene Verkabelung sowie die dafür im Fahrzeug vorgesehene Steuervorrichtung zur Ansteuerung der im Außengriff des Fahrzeugs integrierten optischen Anzeigeeinheit genutzt werden, so dass keine zusätzliche Verkabelung in Türen oder Verkleidungsteilen des Fahrzeugs zum Betrieb der im Außengriff integrierten optischen Anzeigeeinheit eingebaut werden muss. Auch bei dem optischen Identifikationsgeber kann die bereits im Gehäuse des Identifikationsgebers integrierte Elektronik und eine vorhandene optische Anzeigeeinheit verwendet und um die Funktionalität der Darstellung des Ladezustandes der Batterieeinheit auf kostengünstige Weise erweitert werden.

Denkbar ist, dass der Außengriff ein Griff eines Deckels oder einer Klappe des Fahrzeugs ist. Dadurch ist die im Außengriff integrierte optische Anzeigeeinheit an einer Position an der Fahrzeugaußenseite angeordnet, die infolge ihrer üblichen Funktion vom Benutzer des Fahrzeugs besonders gut wahrnehmbar ist.

In weiterer Ausgestaltung der Erfindung ist vorgesehen, dass die optische Anzeigeeinheit zumindest eine lichtemittierende Diode umfasst. Bei einer aus mehreren lichtemittierenden Dioden bestehenden optischen Anzeige kann es sich um herkömmliche (anorganische) lichtemittierende Dioden (LED) oder um organische lichtemittierende Dioden (OLED) handeln. Sowohl herkömmliche LEDs als auch OLEDs bieten die Möglichkeit, den Ladezustand der Batterieeinheit dem Benutzer optisch gut sichtbar und schnell erfassbar zugänglich zu machen. Dies kann in alternativer Ausgestaltung auch dadurch erreicht werden, dass die optische Anzeigeeinheit eine LCD-Anzeige umfasst.

Um dem Benutzer des Fahrzeugs die Information hinsichtlich des Ladezustandes der Batterieeinheit schnell und auf einfache Weise anzuzeigen, sieht die Erfindung in weiterer Ausgestaltung vor, dass die auf der optischen Anzeigeeinheit dargestellte Information über den aktuellen Ladezustand der Batterieeinheit zumindest ein alphanumerisches Zeichen und/oder zumindest eine Graphik umfasst. Beispielsweise kann die Darstellung des Ladezustands mittels einer entsprechenden prozentualen Angabe oder mittels eines Balkendiagramms erfolgen.

Visuell besonders eindringlich wahrnehmbar wird die Darstellung des Ladezustandes, wenn die optische Anzeigeeinheit den Ladezustand der Batterieeinheit ein- oder mehrfarbig darstellt. Dadurch kann beispielsweise bei einer Darstellung in roter Farbe kenntlich gemacht werden, dass die Batterieeinheit ein Minimum an Energie aufweist und umgehend eine Aufladung der Batterieeinheit erfolgen muss. Hierbei würde die Farbe dann als zusätzlicher Warnhinweis dienen.

In Weiterbildung der Erfindung kann die optische Anzeigeeinheit die Position des Außengriffs anzeigen und/oder einen am Außengriff angeordneten Tastschalter beleuchten. Dadurch erhöht sich die Funktionalität der optischen Anzeigeeinheit, so dass diese bei Dunkelheit das Auffinden des Außengriffes erleichtert.

Die Funktionalität der erfindungsgemäßen Außentürgriffanordnung kann ferner dadurch erhöht werden, in dem die optische Anzeigeeinheit nicht nur den Außengriff, sondern auch das Vorfeld im Bereich vor dem Außengriff beleuchtet. Dadurch ist es beispielsweise möglich, den Einstiegsbereich vollständig auszuleuchten und das Einsteigen in das Fahrzeug zu erleichtern.

Indem die optische Anzeigeeinheit ferner den Verriegelungs- und/oder Entriegelungszustand der entsprechenden Fahrzeugtür und/oder des Deckels und/oder der Klappe anzeigt, ist es für den Benutzer aus einer gewissen Distanz zum Fahrzeug erkennbar, ob die entsprechende Tür und/oder der Deckel und/oder die Klappe verriegelt bzw. entriegelt ist.

Alternativ kann das die Darstellung des aktuellen Ladezustands der Batterieeinheit auslösende Ereignis eine Annäherung eines berechtigten Identifikationsgebers an das Fahrzeug sein, so dass bei hinreichender Annäherung in den Sende- und Empfangsbereich von Identifikationsgeber und Fahrzeug auf eine Betätigung eines am Identifikationsgebers ausgebildeten Betätigungselements verzichtet werden kann.

Ein weiteres, die Darstellung des aktuellen Ladezustands der Batterieeinheit auslösendes Ereignis kann eine Aufladung der Batterieeinheit sein, wobei die Aufladung üblicherweise an einer Aufladestation für Fahrzeuge mit Elektroantrieb erfolgt.

Um eine manuell ausgelöste Abfrage hinsichtlich des Ladezustandes der Batterieeinheit zu vermeiden, kann in weiterer Ausgestaltung des erfindungsgemäßen Verfahrens der Identifikationsgeber zur Abfrage des aktuellen Ladezustandes der Batterieeinheit in den gemeinsamen Sende- und Empfangsbereich von Fahrzeug und Identifikationsgeber gebracht werden.

Von der Erfindung ist ferner auch die Verwendung einer aus zumindest einer lichtemittierenden Diode bestehenden optischen Anzeigeeinheit zur Darstellung des Ladezustandes einer Batterieeinheit zur Speisung eines Fahrzeugs mit Elektroantrieb erfasst, wobei die optische Anzeigeeinheit in einem Außengriff einer Tür und/oder einer Klappe des Fahrzeugs integriert ist und für einen Benutzer von außerhalb des Fahrzeugs visuell erfassbar ist.

Es versteht sich, dass die vorstehend genannten und nachstehend noch zu erläuternden Merkmale nicht nur in der jeweils angegebenen Kombination, sondern auch in anderen Kombinationen verwendbar sind. Der Rahmen der Erfindung ist nur durch die Ansprüche definiert.

Weitere Einzelheiten, Merkmale und Vorteile des Gegenstandes der Erfindung ergeben sich aus der nachfolgenden Beschreibung im Zusammenhang mit der Zeichnung, in der beispielhaft ein bevorzugtes Ausführungsbeispiel der Erfindung dargestellt ist. In der Zeichnung zeigt:
- Fig. 1: in schematischer Darstellung eine Draufsicht auf einen erfindungsgemäßen Außengriff und
- Fig. 2: in schematischer Darstellung eine Draufsicht auf einen Identifikationsgebers.

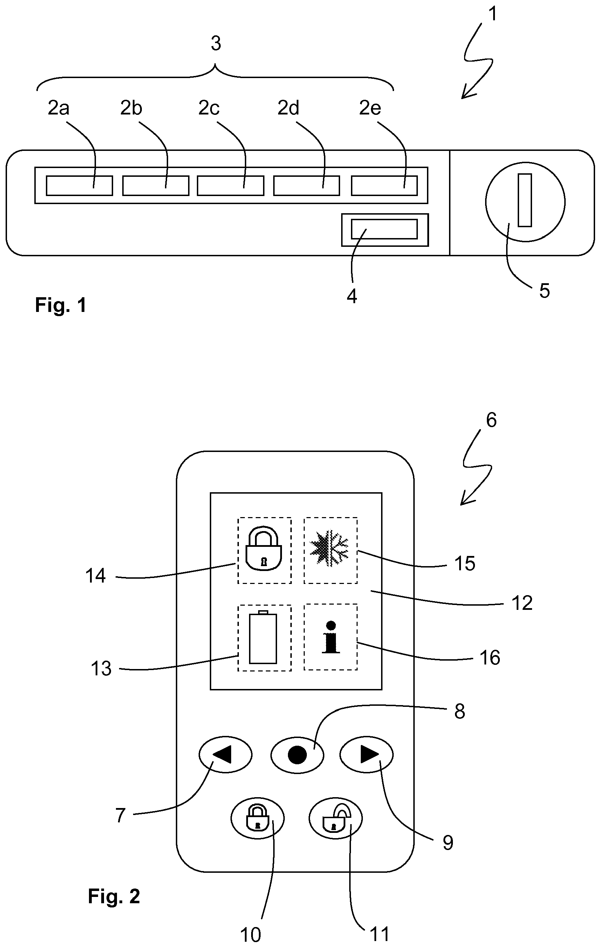

Die Fig. 1 zeigt in schematischer Darstellung eine Draufsicht auf einen eine Außengriffanordnung darstellenden Außengriff 1. Der Außengriff 1 ist ein Türgriff einer Fahrertür eines Fahrzeugs. Die Erfindung ist aber nicht auf einen Türgriff der Fahrertür beschränkt. Denkbar ist, dass der Außengriff 1 ein Griff irgendeiner Tür des Fahrzeugs oder ein Griff eines Deckels oder einer Klappe ist. Der in dieser Ausführungsform exemplarisch dargestellte Außengriff 1 weist fünf lichtemittierende Dioden (LEDs) 2a, 2b, 2c, 2d und 2e auf, die der Reihe nach nebeneinander liegend an dem Außengriff 1 angeordnet sind und in diesen nach außen sichtbar eingebaut sind. Die lichtemittierenden Dioden 2a, 2b, 2c, 2d, 2e bilden eine optische Anzeigeeinheit 3, die den Ladezustand einer nicht dargestellten Batterieeinheit anzeigt. Die Batterieeinheit dient der Versorgung einer Antriebseinrichtung eines Fahrzeugs mit Elektromotor (Elektro- oder Hybridfahrzeug) und umfasst zumindest eine, in der Regel mehrere, Lithium-Batterien, die eine Leistung zwischen 20 und 100 PS und Reichweiten von 300 bis 500 km ermöglichen.

In Abhängigkeit des Ladezustandes der Batterieeinheit werden die nebeneinander liegend angeordneten LEDs 2a, 2b, 2c, 2d, 2e der optischen Anzeigeeinheit 3 angesteuert und leuchten entsprechend für einen vorgegebenen Zeitraum auf, um einem Benutzer den Ladezustand der Batterieeinheit optisch erfassbar darzustellen. Beispielsweise kann die Dauer der auf der optischen Anzeigeeinheit 3 angezeigten Information über den aktuellen Ladezustand zehn Sekunden betragen, so dass nach dieser Zeitdauer die LEDs 2a, 2b, 2c, 2d, 2e wieder ausgeschaltet werden und nicht mehr aufleuchten. Es kann selbstverständlich auch eine kürzere oder längere Zeitdauer des Aufleuchtens gewählt werden, die darüber hinaus vom Benutzer einstellbar sein kann. Denkbar ist aber auch ein mehrmaliges kurzes Aufleuchten der LEDs 2a, 2b, 2c, 2d, 2e, um den Benutzer auf den aktuellen Ladezustand aufmerksam zu machen. Der Ladezustand der Batterieeinheit selbst wird anteilsmäßig von den LEDs 2a, 2b, 2c, 2d, 2e angezeigt. Damit ist gemeint, dass in der dargestellten Ausführungsform bei einem Ladezustand von 40% die LEDs 2a und 2b angesteuert werden und aufleuchten. Bei einem Ladezustand von 100% werden alle LEDs 2a, 2b, 2c, 2d, 2e der optischen Anzeigeeinheit 3 angesteuert und leuchten auf. Es ist ersichtlich, dass sich die prozentuale Genauigkeit der Darstellung des Ladezustandes mit steigender Anzahl von verwendeten LEDs erhöht. Mittels einer Vielzahl von LEDs lässt sich die Information des aktuellen Ladezustands der Batterieeinheit auch in Form eines oder mehrerer alphanumerischer Zeichen und/oder in Form einer oder mehrerer Graphiken darstellen. Alternativ kann für eine solche Darstellung anstelle von LEDs eine LCD-Anzeige als optische Anzeigeeinheit 3 verwendet werden. Dadurch ist eine graphische oder symbolhafte Darstellung des aktuellen Ladezustandes, beispielsweise in Form eines Balkendiagramms, oder eine genaue prozentuale Zahlenangabe des aktuellen Ladezustandes möglich. Die optische Anzeigeeinheit 3 kann sowohl für die Ausführung mit LEDs 2a, 2b, 2c, 2d, 2e als auch für eine Ausführung als LCD-Anzeige den Ladezustand der Batterieeinheit mehrfarbig darstellen, um durch diesen visuellen Effekt den Benutzer des Fahrzeuges auf einen besonders kritischen Ladezustand der Batterieeinheit aufmerksam zu machen.

Die Information über den aktuellen Ladezustand der Batterieeinheit wird von einer in den Figuren nicht dargestellten bekannten Vorrichtung zur Bestimmung des Ladezustandes der Batterieeinheit ermittelt und dann an eine im Fahrzeug vorgesehene zentrale Steuereinheit weitergeleitet, durch welche die optische Anzeigeeinheit 3 angesteuert wird und den aktuellen Ladezustand der Batterieeinheit optisch erfassbar darstellt.

In dem dargestellten Ausführungsbeispiel verfügt der als Türgriff der Fahrertür ausgebildete Außengriff 1 über eine elektrisch betriebene Schließvorrichtung, bei der das Ver- und Entriegeln der Tür mittels eines von der zentralen Steuereinheit angesteuerten Motors erfolgt. Die hierzu vorhandene Verkabelung wird zusätzlich zur Ansteuerung und Energieversorgung der LEDs 2a, 2b, 2c, 2d, 2e oder der LCD-Anzeige der optischen Anzeigevorrichtung 3 verwendet. Die im Außengriff 1 integrierte optische Anzeigevorrichtung 3 weist ferner eine zusätzliche LED 4 auf, die den Verriegelungszustand der Fahrzeugtür anzeigt.

Die Schließvorrichtung des Außengriffs 2 wird üblicherweise elektrisch betrieben und kann einen in Fig. 1 nicht dargestellten Tastschalter aufweisen, der zum Öffnen der Fahrzeugtür manuell vom Benutzer gedrückt wird. Aus Sicherheitsgründen ist vorgesehen, dass die Schließvorrichtung auch mechanisch betrieben werden kann. Zu diesem Zweck weist der Außengriff 1 einen Schließzylinder 5 auf, so dass die Schließvorrichtung im Bedarfsfall mittels eines Notschlüssels vom Benutzer mechanisch entriegelt und/oder verriegelt werden kann. Da der Außengriff 1 bei Dunkelheit nur schwer aufzufinden ist, ist die optische Anzeigeeinheit 3 derart am Außengriff 1 angeordnet, dass sie bei Dunkelheit die Position des Außengriffes 1 anzeigt und/oder den am Außengriff angeordneten Tastschalter beleuchtet, damit sich der Benutzer des Fahrzeugs in der Nacht besser orientieren kann und zielsicher den Außengriff 1 zur Öffnung der Fahrertür auffinden kann. Neben einer Beleuchtung des Außengriffes 1 kann die optische Anzeigeeinheit 3 ferner zur Beleuchtung des Vorfelds im Bereich vor dem Außengriff 1 dienen, um den Komfort und die Sicherheit beim Einsteigen in das Fahrzeug zu erhöhen. Um allerdings die vorstehend genannten Funktionalitäten hinsichtlich der Beleuchtung erfüllen zu können, müssen entsprechend lichtstarke LEDs oder eine entsprechend lichtstarke LCD-Anzeige gewählt werden. Neben einer hinreichenden Licht- bzw. Strahlungsstärke der optischen Anzeigeeinheit 3 muss deren ausgestrahltes Licht auf den zu beleuchtenden Bereich, d.h. in Richtung des Bodens, ausgerichtet werden.

Wie vorstehend bereits ausgeführt, erfolgt die Darstellung des aktuellen Ladezustandes der Batterieeinheit mittels der optischen Anzeigeeinheit 3 nicht dauerhaft, sondern setzt ein auslösendes Ereignis voraus, welches die optische Anzeigeeinheit 3 aktiviert. Ein solches Ereignis, durch welches der Ladezustand der Batterieeinheit mit Hilfe der optischen Anzeigevorrichtung 3 dargestellt wird, ist in dem vorliegenden Ausführungsbeispiel eine Handhabung eines berechtigten Identifikationsgebers (ID-Gebers) 6, bei dem ein entsprechendes Betätigungselement gedrückt wird. Der Einsatz eines wie in Fig. 2 dargestellten mobilen Identifikationsgebers 6, der auch als elektronischer Schlüssel bezeichnet wird, ist für Anwendungen bei Kraftfahrzeugen zur Erhöhung des Bedienerkomforts bekannt. Nach einer entsprechenden Handhabung bzw. Betätigung des Identifikationsgebers 6 durch den Benutzer erfolgt eine Datenkommunikation bzw. ein Austausch von Signalen zwischen dem mobilen Identifikationsgeber 6 und einer Sende- und Empfangseinheit, welche im Fahrzeug angeordnet ist. Im Rahmen der Datenkommunikation wird ein Code ausgetauscht, wobei im Fall einer positiven Auswertung des Codes anschließend beispielsweise die Türen oder der Kofferraumdeckel des Kraftfahrzeuges fernbedienbar ent- und/oder entriegelt sowie weitere Funktionen ausgelöst werden können.

Die Datenkommunikation kann aber auch auf passive Weise ohne Betätigung des Identifikationsgebers 6 erfolgen, indem der Identifikationsgeber 6 in den Sende- und Empfangsbereich des Fahrzeugs gebracht wird, d.h. indem sich der Identifikationsgeber 6 dem Fahrzeug annähert. Der beispielhaft in Fig. 2 dargestellte Identifikationsgeber 6 umfasst mehrere Betätigungselemente 7, 8, 9, 10, 11 und eine optische Anzeigeeinheit 12, auf der ein Menüfeld mit verschiedenen Menüpunkten 13, 14, 15, 16 darstellbar ist, über das kraftfahrzeugseitige Zustandsinformationen abfragbar, neu eingebbar oder veränderbar sind. Die neu eingegebenen oder veränderten Informationen werden hierbei von einer in dem Identifikationsgeber 6 integrierten Sende- und Empfangseinheit zum fahrzeugseitigen Teil übermittelt. Über das Menüfeld der optischen Anzeigeeinheit 12 kann der Benutzer die tatsächlichen Zustandsinformationen des Fahrzeugs abfragen und beispielsweise auf einen Blick feststellen, wie der aktuelle Ladezustand der Batterieeinheit ist (Menüpunkt 13), ob die Fahrzeugtüren und Fenster geschlossen sind, die Alarmanlage aktiviert ist oder ob sich die Schließvorrichtung im entriegelten oder verriegelten Zustand befindet (Menüpunkt 14). Ferner ist es denkbar, über einen Menüpunkt 16 aktuelle Zustandsinformationen wie Kilometerstand, Reifendruck, Parkzeit oder den Termin der nächsten Inspektion abzufragen. Des Weiteren bietet dies die Möglichkeit, Zustandsinformationen neu einzugeben oder zu verändern, die zum fahrzeugseitigen Teil übermittelt werden. Beispielsweise kann über die Anzeigeeinheit 12 des Informationsgebers 6 die Klimaanlage oder die Standheizung des Fahrzeugs über einen Menüpunkt 15 angesprochen und aktiviert werden, indem beispielsweise die gewünschte Temperatur oder die Einschaltzeit über das Menüfeld eingegeben wird und diese neuen Informationen zu dem Fahrzeug gesendet werden. Diese auf der optischen Anzeigeeinheit 12 des Identifikationsgebers 6 dargestellten Menüpunkte 13, 14, 15, 16 sind mittels der Betätigungselemente 7, 8, 9 aufrufbar und anwählbar. Mit Hilfe der Betätigungselemente 10 und 11 wird die elektrisch betriebene Schließvorrichtung des Fahrzeugs, üblicherweise die Zentralverriegelung, direkt angesprochen, so dass das Fahrzeug bei Handhabung bzw. Drücken des Betätigungselements 10 verriegelt und bei Handhabung bzw. Drücken des Betätigungselements 11 entriegelt wird. Aus Sicherheitsgründen kann in dem Gehäuse des mobilen Identifikationsgebers 6 ein Notschlüssel untergebracht sein, der zur Betätigung des mechanischen Schlosses des Fahrzeuges bzw. des Schließzylinders 5 dient.

Die in Fig. 2 dargestellte optische Anzeigeeinheit 12 des Identifikationsgebers 6 ist als eine LCD-Anzeige ausgebildet, auf der die Information des aktuellen Ladezustands der Batterieeinheit beispielsweise als alphanumerisches Zeichen und/oder graphisch dargestellt werden. Denkbar ist beispielsweise, die Information des aktuellen Ladezustandes der Batterieeinheit zahlenmäßig als prozentuale Angabe und/oder graphisch als Balkendiagramm anzuzeigen. Denkbar ist hierbei auch, die durchschnittliche Reichweite auf Basis des aktuellen Ladezustandes der Batterieeinheit anzuzeigen. Die Information des Ladezustandes kann darüber hinaus ein- oder mehrfarbig auf der optischen Anzeigeeinheit 12 dargestellt werden. Im Fall eines kritischen Ladezustandes bietet es sich an, die Information in roter Farbe oder roter Schrift darzustellen, wohingegen ein unkritischer Ladezustand der Batterieeinheit in neutraler Darstellungsweise erfolgt.

Die vorgestellte Außengriffanordnung mit Außengriff 1 und der Identifikationsgeber 6 können somit zur Darstellung von Informationssignalen über den Ladezustand einer zur Speisung eines Fahrzeugs mit Elektroantrieb dienenden Batterieeinheit eingesetzt und verwendet werden. Dabei wird im Rahmen der vorstehend beschriebenen Datenkommunikation von dem berechtigten Identifikationsgeber 6 ein den aktuellen Ladezustand der Batterieeinheit betreffendes Abfragesignal entweder automatisch oder mittels Betätigung eines am Identifikationsgebers 6 ausgebildeten Betätigungselements an das Fahrzeug gesendet. Dieses Signal sorgt dafür, dass der aktuelle Ladezustand der Batterieeinheit von dem Fahrzeug bzw. einer dazu bestimmten Vorrichtung ermittelt wird. Anschließend wird der aktuelle Ladezustand der Batterieeinheit in Form eines Informationssignals an die optische Anzeigeeinheit 3 des Außengriffs 1 übertragen. Die in dem übertragenen Informationssignal enthaltene Information über den aktuellen Ladezustand der Batterieeinheit wird von der optischen Anzeige 3 des Außengriffs optisch erfassbar dargestellt. Beim Senden des Abfragesignals wird der Identifikationsgeber 6 zur Abfrage des aktuellen Ladezustandes der Batterieeinheit in den gemeinsamen Sende- und Empfangsbereich von Fahrzeug und Identifikationsgeber 6 gebracht.

## Patentansprüche

1. Außengriffanordnung eines Fahrzeugs mit Elektroantrieb, die eine den Ladezustand einer Batterieeinheit darstellende optische Anzeigeeinheit (3) aufweist, die von einer Vorrichtung zur Bestimmung des Ladezustandes der Batterieeinheit Informationssignale über den aktuellen Ladezustand der zur Speisung des Fahrzeugs dienenden Batterieeinheit erhält, wobei die optische Anzeigeeinheit (3) den aktuellen Ladezustand der Batterieeinheit in Reaktion auf ein die optische Anzeigeeinheit (3) aktivierendes Ereignis darstellt,
**dadurch gekennzeichnet,**
**dass** die optische Anzeigeeinheit (3) in einem Außengriff (1) des Fahrzeugs integriert ist, wobei das die Darstellung des aktuellen Ladezustands der Batterieeinheit auslösende Ereignis eine Betätigung eines an einem berechtigten Identifikationsgeber (6) ausgebildeten Betätigungselements (7, 8, 9) ist.

2. Außengriffanordnung eines Fahrzeugs mit Elektroantrieb, die eine den Ladezustand einer Batterieeinheit darstellende optische Anzeigeeinheit (3) aufweist, die von einer Vorrichtung zur Bestimmung des Ladezustandes der Batterieeinheit Informationssignale über den aktuellen Ladezustand der zur Speisung des Fahrzeugs dienenden Batterieeinheit erhält, wobei die optische Anzeigeeinheit (3) den aktuellen Ladezustand der Batterieeinheit in Reaktion auf ein die optische Anzeigeeinheit (3) aktivierendes Ereignis darstellt,
**dadurch gekennzeichnet,**
**dass** die optische Anzeigeeinheit (3) in einem Außengriff (1) des Fahrzeugs integriert ist, wobei das die Darstellung des aktuellen Ladezustands der Batterieeinheit auslösende Ereignis eine Annäherung eines berechtigten Identifikationsgebers (6) an das Fahrzeug ist.

3. Außengriffanordnung nach Anspruch 1 oder 2, wobei der Außengriff (1) ein Türgriff, vorzugsweise der Türgriff der Fahrzeugfahrertür, ist.

4. Außengriffanordnung nach Anspruch 1 oder 2, wobei der Außengriff (1) ein Griff eines Deckels oder einer Klappe des Fahrzeugs ist.

5. Außengriffanordnung nach einem der vorhergehenden Ansprüche, wobei die optische Anzeigeeinheit (3) zumindest eine lichtemittierende Diode (2a, 2b, 2c, 2d, 2e) umfasst.

6. Außengriffanordnung nach einem der vorhergehenden Ansprüche, wobei die optische Anzeigeeinheit (3) eine LCD-Anzeige umfasst.

7. Außengriffanordnung nach einem der vorhergehenden Ansprüche, wobei die auf der optischen Anzeigeeinheit (3) dargestellte Information über den aktuellen Ladezustand der Batterieeinheit zumindest ein alphanumerisches Zeichen und/oder zumindest eine Graphik umfasst.

8. Außengriffanordnung nach einem der vorhergehenden Ansprüche, wobei die optische Anzeigeeinheit (3) den Ladezustand der Batterieeinheit ein- oder mehrfarbig darstellt.

9. Außengriffanordnung nach einem der vorhergehenden Ansprüche, wobei die optische Anzeigeeinheit (3) die Position des Außengriffs (1) anzeigt und/oder einen am Außengriff (1) angeordneten Tastschalter beleuchtet.

10. Außengriffanordnung nach Anspruch 8, wobei die optische Anzeigeeinheit (3) das Vorfeld im Bereich vor dem Außengriff (1) beleuchtet.

11. Außengriffanordnung nach einem der vorhergehenden Ansprüche, wobei die optische Anzeigeeinheit (3, 4) ferner den Verriegelungs- und/oder Entriegelungszustand der entsprechenden Fahrzeugtür und/oder des Deckels und/oder der Klappe anzeigt.

12. Außengriffanordnung nach einem der vorhergehenden Ansprüche, wobei das die Darstellung des aktuellen Ladezustands der Batterieeinheit auslösende Ereignis eine Aufladung der Batterieeinheit ist.

13. Verfahren zur Abfrage von Informationssignalen über den Ladezustand einer zur Speisung eines Fahrzeugs mit Elektroantrieb dienenden Batterieeinheit, bei dem von einem berechtigten Identifikationsgeber ein den aktuellen Ladezustand der Batterieeinheit betreffendes Abfragesignal an das Fahrzeug gesendet wird, der aktuelle Ladezustand der Batterieeinheit von dem Fahrzeug ermittelt wird, und der aktuelle Ladezustand der Batterieeinheit in Form eines Informationssignals an eine optische Anzeigeeinheit, die in einem Außengriff des Fahrzeugs integriert ist, übertragen wird,
wobei der in dem übertragenen Informationssignal enthaltene aktuelle Ladezustand der Batterieeinheit von der optischen Anzeigeeinheit optisch erfassbar dargestellt wird, und wobei durch Betätigung eines am berechtigten Identifikationsgeber ausgebildeten Betätigungselements das Abfragesignal über den aktuellen Ladezustand der Batterieeinheit an das Fahrzeug gesendet wird.

14. Verfahren zur Abfrage von Informationssignalen über den Ladezustand einer zur Speisung eines Fahrzeugs mit Elektroantrieb dienenden Batterieeinheit, bei dem von einem berechtigten Identifikationsgeber ein den aktuellen Ladezustand der Batterieeinheit betreffendes Abfragesignal an das Fahrzeug gesendet wird, der aktuelle Ladezustand der Batterieeinheit von dem Fahrzeug ermittelt wird, und der aktuelle Ladezustand der Batterieeinheit in Form eines Informationssignals an eine optische Anzeigeeinheit, die in einem Außengriff des Fahrzeugs integriert ist, übertragen wird,
wobei der in dem übertragenen Informationssignal enthaltene aktuelle Ladezustand der Batterieeinheit von der optischen Anzeigeeinheit optisch erfassbar dargestellt wird, und wobei der Identifikationsgeber zur Abfrage des aktuellen Ladezustandes der Batterieeinheit in den gemeinsamen Sende- und Empfangsbereich von Fahrzeug und Identifikationsgeber gebracht wird.

## Claims

1. External handle arrangement of a vehicle with electric drive, having a visual display unit (3) which displays the charging condition of a battery unit, which receives information signals about the current state of charge of the battery serving to supply the vehicle battery unit from a device for determining the charge state of the battery unit, wherein the visual display unit (3) displays the current state of charge of the battery in response to an event that activates the visual display unit (3),
**characterized in that**
the visual display unit (3) is integrated in an outer handle (1) of the vehicle, wherein the event that triggers the display of the current state of charge of the battery unit is an actuation of an actuating element (7, 8, 9) provided on an authorized identification transmitter (6).

2. External handle arrangement of a vehicle with electric drive, having a visual display unit (3) which displays the charging condition of a battery unit, which receives information signals about the current state of charge of the battery serving to supply the vehicle battery unit from a device for determining the charge state of the battery unit, wherein the visual display unit (3) displays the current state of charge of the battery in response to an event that activates the visual display unit (3),
**characterized in that**
the visual display unit (3) is integrated in an outer handle (1) of the vehicle, wherein the event that triggers the display of the current state of charge of the battery unit is an approach to the vehicle of an authorized identification transmitter (6).

3. External handle arrangement according to Claim 1 or 2, wherein the outer handle (1) is a door handle, preferably the door handle of the vehicle driver's door.

4. External handle arrangement according to Claim 1 or 2, wherein the outer handle (1) is a door handle of a lid or a flap of the vehicle.

5. External handle arrangement according to any one of the preceding claims, wherein the visual display unit (3) comprises at least one light emitting diode (2a, 2b, 2c, 2d, 2e).

6. External handle arrangement according to any one of the preceding claims, wherein the visual display unit (3) comprises an LCD display.

7. External handle arrangement according to any one of the preceding claims, wherein the information about the current state of charge of the battery unit displayed on the visual display unit (3) comprises at least one alphanumeric character and/or at least one graphic element.

8. External handle arrangement according to any one of the preceding claims, wherein the visual display unit (3) displays the state of charge of the battery unit in one or multiple colours.

9. External handle arrangement according to any one of the preceding claims, wherein the visual display unit (3) displays the position of the outer handle (1) and/or illuminates a pushbutton switch arranged on the outer handle (1).

10. External handle arrangement according to Claim 8, wherein the visual display unit (3) illuminates the forward space in the area in front of the outer handle (1).

11. External handle arrangement according to any one of the preceding claims, wherein the visual display unit (3, 4) further displays the locked and/or unlocked status of the corrsponding vehicle door and/or of the lid and/or flap.

12. External handle arrangement according to any one of the preceding claims, wherein a charging operation of the battery unit is a triggering event for the display of the current state of charge of the battery unit.

13. Method for querying information signals about the charge state of a battery unit serving to supply electrical propulsion for a motor vehicle, in which a query signal regarding the current state of charge of the battery unit is transmitted to the motor vehicle by an authorized identification transmitter, the current state of charge of the battery unit is determined by the motor vehicle, and the current state of charge of the battery unit is transferred in the form of an information signal to a visual display unit which is integrated in an external handle of the vehicle,
wherein the current state of charge of the battery unit contained in the transmitted information signal is presented in visually perceptible manner by the visual display unit, and wherein the query signal regarding the current state of charge of the battery unit is sent to the motor vehicle by actuation of an actuation element provided on the authorized identification transmitter.

14. Method for querying information signals about the charge state of a battery unit serving to supply electrical propulsion for a motor vehicle, in which a query signal regarding the current state of charge of the battery unit is transmitted to the motor vehicle by an authorized identification transmitter, the current state of charge of the battery unit is determined by the motor vehicle, and the current state of charge of the battery unit is transferred in the form of an information signal to a visual display unit which is integrated in an external handle of the vehicle,
wherein the current state of charge of the battery unit contained in the transmitted information signal is presented in visually perceptible manner by the visual display unit, and wherein the identification transmitter is brought into the common transmission and receiving range of the vehicle and the identication transmitter in order to query the current state of charge of the battery unit.

## Revendications

1. Ensemble de poignée extérieure d'un véhicule avec entraînement électrique, qui comporte une unité d'affichage optique (3) représentant l'état de charge d'une unité de batterie, qui reçoit des signaux d'information concernant l'état de charge actuel de l'unité de batterie servant à alimenter le véhicule venant d'un dispositif de détermination de l'état de charge de l'unité de batterie, l'unité d'affichage optique (3) représentant l'état de charge actuel de l'unité de batterie en réaction à un évènement activant l'unité d'affichage optique (3),
**caractérisé en ce que**
l'unité d'affichage optique (3) est intégrée dans une poignée extérieure (1), l'événement déclenchant
la représentation de l'état de charge actuel de l'unité de batterie étant un actionnement d'un élément de commande (7,8,9) constitué sur un détecteur d'identification autorisé (6).

2. Ensemble de poignée extérieure d'un véhicule avec entraînement électrique, qui comporte une unité d'affichage optique (3) représentant l'état de charge d'une unité de batterie, qui reçoit des signaux d'information concernant l'état de charge actuel de l'unité de batterie servant à alimenter le véhicule venant d'un dispositif de détermination de l'état de charge de l'unité de batterie, l'unité d'affichage optique (3) représentant l'état de charge actuel de l'unité de batterie en réaction à un évènement activant l'unité d'affichage optique (3), **caractérisé en ce que** l'unité d'affichage optique (3) est intégrée dans une poignée extérieure (1) du véhicule, l'évènement déclenchant la représentation de l'état de charge actuel de l'unité de batterie étant une approche d'un détecteur d'identification autorisé (6).

3. Ensemble de poignée extérieure selon la revendication 1 ou 2, la poignée extérieure (1) étant une poignée de porte, de préférence la poignée de porte de la porte du véhicule.

4. Ensemble de poignée extérieure selon la revendication 1 ou 2, la poignée extérieure (1) étant une poignée d'un capot ou d'un hayon du véhicule.

5. Ensemble de poignée extérieure selon l'une quelconque des revendications précédentes, l'unité d'affichage optique (3) comprenant au moins une diode électroluminescente (2a,2b,2c,2d,2e).

6. Ensemble de poignée extérieure selon l'une quelconque des revendications précédentes, l'unité d'affichage optique (3) comprenant un affichage à cristaux liquides (ACL).

7. Ensemble de poignée extérieure selon l'une quelconque des revendications précédentes, l'information représentée sur l'unité d'affichage optique (3) concernant l'état de charge actuel de l'unité de batterie comprenant au moins un signe alphanumérique et/ou au moins un graphique.

8. Ensemble de poignée extérieure selon l'une quelconque des revendications précédentes, l'unité d'affichage optique (3) représentant l'état de charge de l'unité de batterie de façon mono- ou polychrome.

9. Ensemble de poignée extérieure selon l'une quelconque des revendications précédentes, l'unité d'affichage optique (3) affichant la position de la poignée extérieure (1) et/ou un bouton-poussoir disposé sur la poignée extérieure (1).

10. Ensemble de poignée extérieure selon la revendication 8, l'unité d'affichage optique (3) éclairant la zone avant dans le secteur situé devant la poignée extérieure (1).

11. Ensemble de poignée extérieure selon l'une quelconque des revendications précédentes, l'unité d'affichage optique (3,4) affichant en outre l'état de verrouillage et/ou de déverrouillage de la porte de véhicule correspondante et/ou du capot et/ou du hayon.

12. Ensemble de poignée extérieure selon l'une quelconque des revendications précédentes, l'évènement déclenchant la représentation de l'état de charge actuel de l'unité de batterie étant l'alimentation de charge de l'unité de batterie.

13. Procédé pour interroger des signaux d'information concernant l'état de charge d'une unité de batterie servant à alimenter un véhicule avec entraînement électrique, pour lequel un signal d'interrogation concernant l'état de charge actuel de l'unité de batterie est envoyé au véhicule par un détecteur d'identification autorisé, l'état de charge actuel de l'unité de batterie est déterminé par le véhicule et l'état de charge actuel de l'unité de batterie est transmis sous la forme d'un signal d'information à une unité d'affichage optique, qui est intégrée dans une poignée extérieure du véhicule, l'état de charge actuel de l'unité de batterie contenu dans le signal d'information transmis étant représenté de façon optiquement saisissable par l'unité d'affichage optique et le signal d'interrogation concernant l'état de charge actuel de l'unité de batterie étant envoyé au véhicule par actionnement d'un élément de commande constitué sur le détecteur d'identification autorisé.

14. Procédé pour interroger des signaux d'information concernant l'état de charge d'une unité de batterie servant à alimenter un véhicule avec entraînement électrique, pour lequel un signal d'interrogation concernant l'état de charge actuel de l'unité de batterie est envoyé au véhicule depuis un détecteur d'identification autorisé, l'état de charge actuel de l'unité de batterie est déterminé par le véhicule et l'état de charge actuel de l'unité de batterie est transmis sous la forme d'un signal d'information à une unité d'affichage optique, qui est intégrée dans une poignée extérieure du véhicule, l'état de charge actuel de l'unité de batterie contenu dans le signal d'information transmis étant représenté de façon optiquement saisissable par l'unité d'affichage optique et le détecteur d'identification pour interroger l'état de charge actuel de l'unité de batterie étant monté dans la zone d'émission et de réception commune du véhicule et du détecteur d'identification.
